# EUROPEAN PATENT APPLICATION

(11) **EP 4 535 237 A1**
(43) Date of publication of application: **09.04.2025**
(21) Application number: 24767308.0
(22) Date of filing: 20.02.2024
(51) Int. Cl.: G06N 3/063, G11C 11/54

(54) **NEURAL NETWORK SYSTEM AND IMPLEMENTATION METHOD THEREOF**

(30) Priority: 07.03.2023 KR 20230029751
(71) Applicant: Pebble Square, Inc., Uiwang-si, Gyeonggi-do 16079 (KR)
(72) Inventor: LEE, Choong Hyun, Cheonan-si, Chungcheongnam-do 31226 (KR)
(74) Representative: Zacco Sweden AB
(86) International application number: PCT/KR2024/002180
(87) International publication number: WO 2024/186019

(57) **Abstract**

A neural network system includes a neural network circuit including first memory cells arranged in an array; and a self-referencing circuit electrically connected to a row line or a column line of the neural network circuit and configured to apply current to the connected row line or column line so that a plurality of target memory cells have preset target weights, wherein the target memory cells include all memory cells positioned on the row line or the column line to which the self-referencing circuit is connected.

## Description

### Technical Field

The present disclosure relates to a neural network system and a method of implementing the same and, more specifically, to an ultra-fast parallel programming method for transplanting a trained model to a large-scale neural network and a neural network system transplanted by the same.

### Background Art

Artificial neural networks imitating biological neural networks may be trained using a large number of input data, and are used to estimate or approximate results difficult to be derived by general techniques. Artificial neural networks respectively include layers of interconnected neurons that exchange signals. In such artificial neural networks, synapses have weights that may be tuned based on learning or experience.

In order for a user to train an artificial neural network, the larger the amount of learning data, the higher the performance is required for a computing device on which the training is to be performed, and the user must be able to perform additional training on an edge device using the trained neural network.

However, in order to accurately implement the trained deep learning model in the embedded SoC of the edge device and to mass produce such edge devices, the accuracy and processing speed of weight programming are very important.

The above background technology is technical information that the inventor possessed for conceiving the present disclosure or acquired in the process of conceiving the present disclosure, and should not be considered prior art already known to the public prior to filing the present disclosure.

### Detailed Description of the disclosure

### Technical Problem

An objective of the present disclosure is to provide a neural network system and a method of implementing the same. The objective of the present disclosure is not limited to the aforementioned description, and other objectives not explicitly disclosed herein will be clearly understood by a person having ordinary skill in the art from the description of the present disclosure, and will be understood more clearly understood according to embodiments of the present disclosure. It will also be appreciated that the above and other objectives and advantages of the present disclosure may be realized by means disclosed in the claims and combinations thereof.

### Technical Solution to Problem

A first aspect of the present disclosure may provide a neural network system including: a neural network circuit including first memory cells arranged in an array; and a self-referencing circuit electrically connected to a row line or a column line of the neural network circuit and configured to apply current to the connected row line or column line so that a plurality of target memory cells each have a preset target weights, wherein the target memory cells include all memory cells positioned on the row line or the column line to which the self-referencing circuit is connected.

A second aspect of the present disclosure may provide a method of implementing a neural network system, the method including: obtaining target weights of first memory cells included in a neural network circuit and arranged in an array form; tuning a self-referencing circuit; and adjusting weights of the neural network circuit by electrically connecting the tuned self-referencing circuit to a row line or a column line of the neural network circuit, wherein the self-referencing circuit applies a current to the connected row line or column line so that a plurality of target memory cells have the target weights, and the target memory cells include all memory cells positioned on the row line or the column line to which the self-referencing circuit is connected.

A third aspect of the present disclosure may provide a computer-readable recording medium having recorded thereon a program to cause the method of the second aspect to be executed on a computer.

In addition, other methods, other devices, and other computer-readable recording media having recorded thereon a program to cause the methods to be executed on a computer for realizing the present disclosure may be provided.

Other aspects, features, and advantages in addition to those described above will become apparent from the following drawings, the claims, and the detailed description of the present disclosure.

### Advantageous Effects of Disclosure

According to embodiments of the present disclosure described above, a method of transplanting a deep neural network model at an ultra-high speed by programming the weights of synaptic elements in parallel in an integrated circuit having a large-scale neural network and a method of operating the same may be provided.

In addition, according to embodiments of the present disclosure, a high-accuracy transplantation device and a method of operating the same may be provided by minimizing disturbances during programming of adjacent synaptic elements even in a case where synaptic elements have high-density weights.

The effects of embodiments are not limited to the effects mentioned above, and other effects not mentioned will be clearly understood by a person having ordinary skill in the art from the description of the present disclosure.

### Brief Description of Drawings

FIG. 1 is a diagram illustrating an implementation of a neural network system according to an embodiment;
FIG. 2 is a diagram illustrating a bit-by-bit programming method according to an embodiment;
FIG. 3 is a conceptual diagram schematically depicting the bit-by-bit programming method according to an embodiment;
FIG. 4 is a conceptual diagram schematically depicting a self-referencing programming method according to an embodiment;
FIG. 5 is an example diagram of a neural network system implemented using self-referential programming according to an embodiment;
FIG. 6 is a diagram illustrating an operation of a self-referencing circuit according to an embodiment;
FIG. 7 is an example diagram of a self-referencing circuit according to an embodiment;
FIG. 8 is a graph showing the result of self-referential programming according to an embodiment; and
FIG. 9 is a flowchart of a method of implementing a neural network system according to an embodiment.

### Best Mode of Disclosure

A neural network system includes a neural network circuit including first memory cells arranged in an array; anda self-referencing circuit electrically connected to a row line or a column line of the neural network circuit and configured to apply current to the connected row line or column line so that a plurality of target memory cells have preset target weights, wherein the target memory cells include all memory cells positioned on the row line or the column line to which the self-referencing circuit is connected.

### Mode of Disclosure

In describing the present disclosure, a detailed explanation of related known configurations may be omitted to avoid obscuring the subject matter of the present disclosure, and all terms used herein have the same meaning as commonly understood by a person having ordinary skill in the art to which the present disclosure belongs unless explicitly stated otherwise.

Phrases such as "according to an embodiment," "relating to an embodiment," or "according to an implementation of an embodiment" in this specification do not necessarily refer to the same embodiment.

Some embodiments will be illustrated in the accompanying drawings and described in detail, since the embodiments may be variously modified in many different forms. However, this is not intended to limit the embodiments to specific disclosed forms, but the present disclosure should be understood to include all modifications, equivalents, and alternatives included within the spirit and scope of the present disclosure. The terms used in the specification are merely used to describe the embodiments and are not intended to limit the embodiments.

The terms used in embodiments are chosen to be general terms that are currently used as broadly as possible while taking into account the functions in the embodiments, but this may vary depending on the intent of a person having ordinary skill in the art to which the embodiments pertain, the precedent, the emergence of new technologies, or the like. In addition, some terms are arbitrarily designated by the applicant for specific cases, and in such cases, the meaning of the terms will be described in detail in the relevant section. Therefore, the terms used in the embodiments should be defined based on the meaning of the terms and the overall content of the embodiments, rather than simply the names of the terms.

Some embodiments of the present disclosure may be represented by function block configurations and various processing steps. Some or all of these function blocks may be implemented using various numbers of hardware and/or software configurations executing specific functions. For example, the function blocks of the present disclosure may be implemented using one or more microprocessors, or may be implemented using circuit configurations for specific functions.

In addition, for example, function blocks of the present disclosure may be implemented using various programming or scripting languages. Function blocks may be implemented using algorithms running on one or more processors. In addition, the present disclosure may employ related-art technologies for electronic environment setup, signal processing, and/or data processing.

Terms such as "database," "element," "means," and "configuration" may be used broadly and are not limited to mechanical or physical components. In addition, it will be understood terms such as "part" or "module" used in this specification refers to a unit of processing at least one function or operation, and the part or module may be implemented using software, hardware, or a combination of software and hardware.

In addition, lines or members connecting components shown in the drawings merely illustrate functional connections and/or physical or circuit connections. In an actual device, components may be represented as connected by various replaceable or additional functional connections, physical connections, or circuit connections.

In addition, it will be understood that terms containing an ordinal, such as "first" or "second", may be used in the specification to describe various elements, these elements should not be limited by these terms. These terms are only used to distinguish one component from another.

In addition, the sizes or proportions of some components shown in the drawings may be exaggerated. In addition, some components shown in one drawing may not be shown in other drawings.

Throughout the specification, embodiments are arbitrary distinctions intended to facilitate the description of the invention in the present disclosure, and are not necessarily mutually exclusive. For example, configurations disclosed in one embodiment may be applied and/or implemented in another embodiment, and may be applied and/or implemented with modifications, without departing from the scope of the present disclosure.

In addition, terms used in the present disclosure are for describing the embodiments and are not intended to limit the embodiments. In the present disclosure, singular forms are intended to include plural forms unless explicitly stated otherwise.

Hereinafter, embodiments of the present disclosure will be described in detail with reference to the accompanying drawings so that a person having ordinary skill in the art may easily put the present disclosure into practice. However, embodiments of the present disclosure may be realized in various different forms and are not limited to the embodiments described in the present disclosure.

Hereinafter, the present disclosure will be described in detail with reference to the drawings.

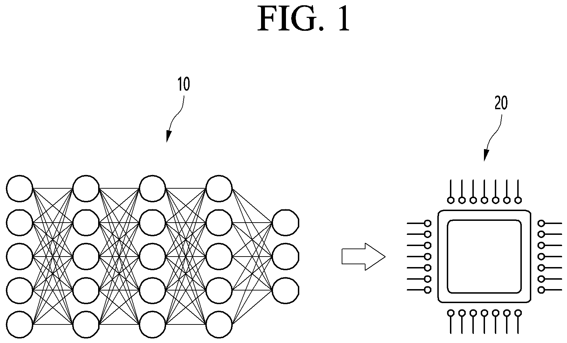

FIG. 1 is a diagram illustrating an implementation of a neural network system according to an embodiment.

Referring to FIG. 1, a trained artificial neural network model 10 and actual hardware 20 may be viewed.

The trained artificial neural network model 10 means that the weight of each layer of the artificial neural network model 10 is determined based on a plurality of learning data. In a case where the weights resulting from the training of the artificial neural network model 10 are stored in a central cloud server, a cloud computing device using the artificial neural network model 10 may communicate with the central cloud server to transmit input values to and receive output values from the artificial neural network model 10. In this case, even in a case where the artificial neural network model 10 is very complex or has a large scale, the output values may be properly used in the cloud computing device.

However, in a case where an edge computing device 20 processes data on the device itself without communicating with the central cloud server, the weights of the artificial neural network model 10, i.e., the weights determined through learning, must be transplanted accurately to the actual hardware 20. This is problematic in a case where the artificial neural network model 10 is very complex or has a large scale.

In a case where each weight in the artificial neural network model 10 has a wide variety of state values (e.g., 128 states), a crossbar array implemented in the actual hardware 20 is formed at a high density. Each memory cell included in a neural network circuit of the actual hardware 20 is positioned on the same word line (WL) and bit line (BL) as the adjacent memory cell. In this regard, a program/erase operation of transplanting the weights into the memory cells may disturb the adjacent memory cells, thereby broadening and shifting current in the adjacent memory cells. This type of disturbance phenomenon may cause the respective state values of the weights in the high-density crossbar array to overlap, thereby making it difficult to place the weights accurately.

In addition, in a case where the artificial neural network model 10 has a large scale, the number of memory cells may be millions or tens of millions. The problem is that to place the artificial neural network model 10 in the hardware 20, weights are transplanted to a large number of memory cells, and the mass production of the hardware 20 is very time consuming.

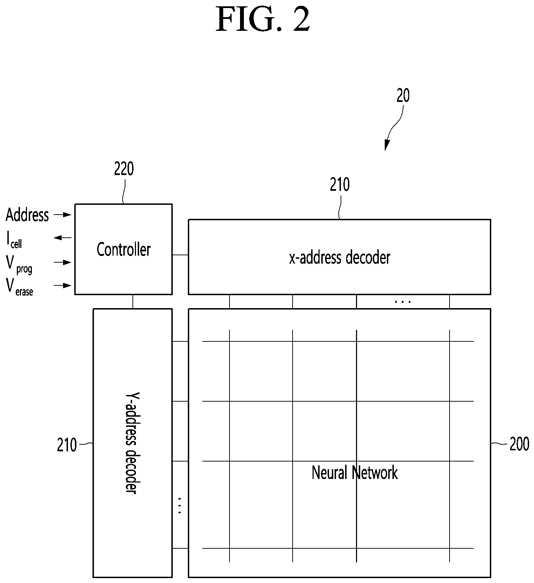

FIG. 2 is a diagram illustrating a bit-by-bit programming method according to an embodiment.

Referring to FIG. 2, the neural network system 20 implemented using the bit-by-bit programming may include a neural network circuit 200, an address decoder 210, and a controller 220.

The neural network circuit 200 may include memory cells arranged in an array.

In an embodiment, the memory cells of the neural network circuit 200 may be flash memory cells. Each of the memory cells includes a source region and a drain region formed on a semiconductor substrate, with a channel region being formed between the source region and the drain region. In addition, a floating gate is formed on at least one of the source region, the drain region, and the channel region, and is insulated from these regions by a gate insulating film.

In an embodiment, the memory cell of the neural network circuit 200 may be a split-gate type memory cell. The split-gate type memory cell includes a source/drain region formed on a semiconductor substrate, with a pair of floating gates being provided on the semiconductor substrate adjacent to both sides of the source/drain region. The upper surface of each of the floating gates is covered with an intergate oxide film, and a control gate is formed to cover the upper surface of the intergate oxide film and is insulated from the floating gate. A gate insulating film is formed between the floating gates and the semiconductor substrate, and a select gate insulated by the gate insulating film is placed on the source/drain region. The control gate and the select gate are insulated by an extension of the intergate oxide film formed between the floating gate and the control gate.

In the split-gate type memory cell, a source region or a drain region may be formed on the semiconductor substrate on both side regions opposite the source/drain region with respect to the floating gates. A cell having a source/drain region operating as a source is referred to as an odd cell, and a cell having a source/drain region operating as a drain is referred to as an even cell. The odd cell and the even cell may have a mirror symmetrical structure with respect to the source/drain region.

In an embodiment, the memory cell of the neural network circuit 200 may have a two-layer crossbar array structure including a crossbar array of row lines and column lines and a crossbar array of word lines and bit lines. The word line terminal is connected to the select gate, and the bit line terminal is connected to the drain region, so that the word line terminal may perform a write (program/erase) operation and the bit line terminal may perform a read operation.

As a high positive voltage is applied to the word line terminal of the memory cell, electrons are removed from the floating gate. This is referred to as an erase operation. Specifically, in a case where a high positive voltage is applied to the word line terminal, electrons in the floating gate tunnel through the insulator from the floating gate and are injected into the select gate. That is, electrons are injected into the word line terminal.

In the memory cell, electrons are injected into the floating gate with a positive voltage applied to the word line terminal and a positive voltage applied to the source region. This is referred to as a program operation. Specifically, in a case where a positive voltage is applied to the word line terminal and the source region, an electron current flows from the source region toward the drain region. As electrons reach between the word line terminal and the floating gate, the electrons are accelerated and heated, and some of the electrons pass through the insulating film due to electrostatic attraction and are injected into the floating gate.

The configuration and arrangement of the source region, the drain region, the channel region, the floating gate, and the select gate of the flash memory cell may vary depending on the structure of the flash memory.

In an embodiment, the memory cell may correspond to not only flash memory, but also resistive random access memory (RRAM), phase-change random access memory (PRAM), magnetic random access memory (MRAM), and the like, and the type of the memory cell is not limited thereto.

The address decoder 210 may include a column decoder (i.e., an X-address decoder) and a row decoder (i.e., a Y-address decoder). The column decoder may include a word line decoder and a bit line decoder. The row decoder may include a source line decoder and a control gate decoder. Each decoder may decode inputs to the memory cell array of the neural network 200. In addition, the source line decoder may decode outputs from the memory cell array of the neural network 200.

The controller 220 may transmit the position of the memory cell at which a read/write operation is to be performed to the address decoder 210, control the write operation by applying program/erase voltages (*V_{prog}* and *Vₑᵣₐₛₑ*), and control the read operation by receiving a current output from the memory cell.

Hereinafter, the bit-by-bit programming method will be described.

The controller 220 may transmit a signal to the address decoder 210 to designate a single memory cell (i.e., a first memory cell, for ease of explanation) for storing the weights, and apply a program/erase voltage to the first memory cell through the corresponding word line to store the weights in the first memory cell. Before or after the program/erase operation, the read operation may be performed through the bit line.

Thereafter, the controller 220 may transmit a signal to the address decoder 210 to designate a second memory cell for storing the weights, and apply a program/erase voltage to the second memory cell through the corresponding word line to store the weights in the second memory cell. Likewise, before or after the program/erase operation, the read operation may be performed through the bit line.

By sequentially applying program/erase voltages to all of the memory cells of the neural network circuit 200 and storing the weights determined from the trained model in this manner, the neural network system 20 may be implemented.

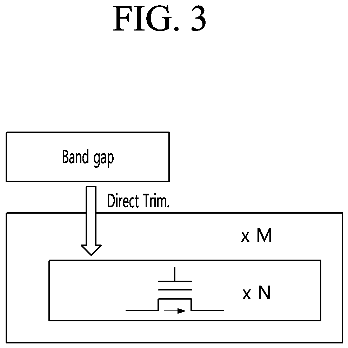

FIG. 3 is a conceptual diagram schematically depicting the bit-by-bit programming method according to an embodiment.

Referring to FIG. 3, in a case where the neural network circuit has M number of row lines and N number of column lines, the bit-by-bit programming method illustrated in FIG. 2 may be roughly viewed.

In bit-by-bit programming operations, weights are directly stored in MxN number of memory cells, i.e., the product of the number of row lines and the number of column lines. That is, a weight trimming operation through the program/erase operation is performed directly for each memory cell.

However, as described above, the weights of memory cells sharing a word line or a bit line may differ from the target weight due to disturbances occurring during the program/erase operation of an adjacent memory cell after the weights are stored and due to expansion and movement of current. The disturbance phenomenon may be enhanced by repeating the program/erase operation, and in the neural network circuit 200 of a high-density crossbar array, the state values of the weights may overlap. This may cause an error in the neural network system 20.

In addition, the problem is that the bit-by-bit programming is not suitable for mass production because a large-scale neural network system must perform write/read operations on each of millions to tens of millions of memory cells.

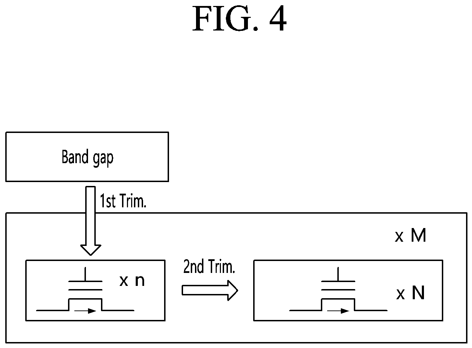

FIG. 4 is a conceptual diagram schematically depicting a self-referencing programming method according to an embodiment.

Weight programming methods for memory cells include a variety of programming methods, such as the bit-by-bit programming method described above and an iterative programming method.

The iterative programming method performs a program/erase operation, i.e., a write operation, on all of the memory cells of the neural network circuit, checks stored weights by a read operation, and then performs the write operation again to remove an error corresponding to a difference value from a target weight.

In this regard, an error correction code may be applied to the write operation to remove the error.

The error value of the target current of the memory cell may be reduced by repeating the write and read operations for all of the memory cells in this manner, and thus the disturbance phenomenon in the adjacent memory cells may be minimized compared to the bit-by-bit programming method described in FIGS. 2 and 3.

However, the high-density crossbar array requires repeating the write/read operations tens of times in order to reduce the error value so that the state values of the weights are sufficiently distinguishable by the write/read operations. Therefore, in the large-scale neural network system, the total programming time is long, and thus the iterative programming method is not suitable for the mass production of products to which the large-scale neural network system is applied.

The iterative programming method is suitable for application in a case where the scale of the neural network system is sufficiently small.

Therefore, in an embodiment according to the present disclosure, a two-step programming method is disclosed that performs weight programming for a small-scale embedded system and performs programming for the entire neural network circuit using the programmed small-scale embedded system.

For example, referring to FIG. 4, a weight trimming operation 1st Trim may be performed on a small-scale crossbar array including n number of memory cells by a program/erase operation, programmed small-scale crossbar arrays may be prepared in the number M of row lines or the number N of column lines and electrically connected to the row lines or the column lines of the neural network circuit, and a weight trimming operation 2nd Trim may be performed on all of the memory cells of the row line or the memory cells of the column line of each of the small-scale crossbar arrays by a program/erase operation.

That is, row-by-row programming or column-by-column programming may be performed.

Hereinafter, a self-referencing programming method according to an embodiment will be described based on row-level programming, but the same may also be applied to column-level programming on the same principle. In addition, in the above description, small-scale embedded systems and small-scale crossbar arrays may refer to self-referencing circuits.

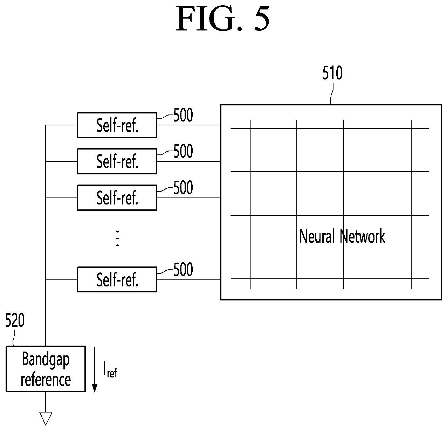

FIG. 5 is an example diagram of a neural network system implemented using self-referential programming according to an embodiment.

Referring to FIG. 5 , the neural network system may include self-referencing circuits 500, a neural network circuit 510, and a band gap circuit 520.

The neural network circuit 510 may include a plurality of memory cells arranged in an array. Hereinafter, the memory cell included in the neural network circuit 510 is referred to as a first memory cell.

In the description of the first memory cell, a description of features overlapping those described above with reference to FIG. 2 will be omitted. That is, the first memory cell may correspond to not only flash memory, but also resistive random access memory (RRAM), phase-change random access memory (PRAM), magnetic random access memory (MRAM), and the like.

The band gap circuit 520 may provide a reference voltage so that a constant voltage is applied to the self-referencing circuits 500. The band gap circuit 520 may operate as a reference voltage source or a reference current source because the output thereof does not change sensitively with the external environment, and thus is also referred to as a band gap referencing circuit. Because the band gap circuit 520 is electrically connected to a plurality of self-referencing circuits 500, the band gap circuit 520 may provide a reference voltage or current so that a constant voltage or current is applied to the self-referencing circuits 500.

In an embodiment, the self-referencing circuits 500 may be electrically connected to row lines of the neural network circuit 510, respectively. In a case where the neural network circuit 510 forms a crossbar array with M number of row lines and N number of column lines, M number of self-referencing circuits 500 may be electrically connected to the row lines of the neural network circuit 510, respectively. Each of the self-referencing circuits 500 may perform weight programming for the first memory cell positioned on the connected row line. Hereinafter, among the first memory cells, all memory cells positioned on the row line to which the self-referencing circuit 500 is connected are defined as target memory cells.

In an embodiment, each of the self-referencing circuits 500 may apply current to the connected row line so that a plurality of target memory cells have preset target weights. For example, the neural network system may further include a write circuit (not shown) performing a programming operation on the target memory cells so that the target memory cells have preset target weights. That is, each of the self-referencing circuits 500 may perform a read operation on the target memory cells, specifically delivering an accurate source voltage to the target memory cells, and the write circuit (not shown) may perform a write operation on the target memory cells.

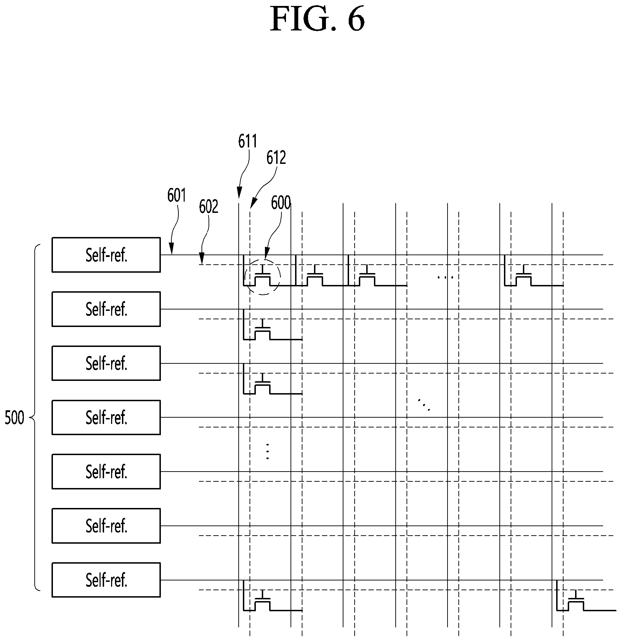

FIG. 6 is a diagram illustrating an operation of a self-referencing circuit according to an embodiment.

Referring to FIG. 6, a crossbar array circuit embodying the neural network circuit 510 of FIG. 5 and a self-referencing circuit 500 may be viewed.

The neural network circuit 510 may include a first crossbar array and a second crossbar array. Memory cells of the neural network circuit 510 may include split gate memory cells to implement a two-layer crossbar array structure. For ease of explanation, a first row line (hereinafter, referred to as a "first row line") 601 and a first column line (hereinafter, referred to as a "first column line") 611 of a first crossbar array and a first row line (hereinafter, referred to as a "first* row line") 602 and a first column line (hereinafter, referred to as a "first* row line") 612 of a second crossbar array will be described.

The first row line 601 may correspond to a source line that supplies a source voltage to memory cell 600. The first column line 611 may correspond to a bit line that performs a read operation. The first* row line 602 may supply an input voltage to the memory cell 600. The first* column line 612 may correspond to a word line that performs a write operation.

In one embodiment, each source region, drain region, and gate of a plurality of first memory cells to the target memory cell 600 positioned in the neural network circuit may be connected to at least one of the row lines or column lines of the neural network circuit. As an example, a target memory cell 600 is positioned on the first row line 601 and the first column line 611 of the neural network circuit, and components of the target memory cell 600 may be electrically connected to the first column line 611, the first * row line 602, and the first* column line 612.

Specifically, the drain region of the target memory cell 600 may be connected to the first column line 611 and receive a drain voltage from the first column line. The control gate of the target memory cell 600 may be connected to the first* row line 602 and receive a gate voltage from the first* row line 602. Accordingly, the first* row line 602 may perform a write operation on the target memory cell 600. The select gate of the target memory cell 600 may be connected to the first* column line 612. The source region of the target memory cell 600 may be electrically connected to the self-referencing circuit 500.

In an embodiment, for the self-referencing circuit 500 connected to the first row line 601, a cell designation circuit (not shown) may select a designated memory cell by designating a specific column line, i.e., a target line. The address of a first memory cell is determined by the intersection of the connected row and column lines, and each of the first memory cells has a preset target weight. Accordingly, the cell designation circuit (not shown) may select a designation memory cell from the self-referencing circuit 500 so that a current corresponding to the target weight may be applied to an appropriate memory cell.

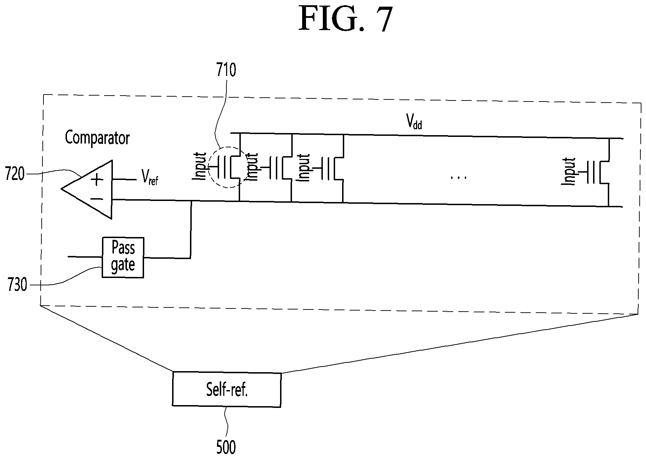

FIG. 7 is an example diagram of a self-referencing circuit according to an embodiment.

Referring to FIG. 7 , the self-referencing circuit 500 may include second memory cells 710, a comparator 720, and a pass gate 730.

In an embodiment, tuning gate voltages may be applied to control gates of the second memory cells 710.

In an embodiment, the second memory cells 710 may be two or more. In a case where the second memory cells 710 are two or more, the second memory cells 710 may be connected to each other in parallel. In addition, different tuning gate voltages may be applied to the control gates of the second memory cells 710 connected in parallel, and different output currents may flow. In this regard, in a case where the second memory cells 710 are in an inactive (turned-off) state, no current flows, and thus the output current may include 0.

In an embodiment, the number of the second memory cells 710 may be determined based on the number of weight state values that the target memory cell may have. For example, in a case where a neural network system is configured such that the first memory cell has 256 state values, the self-referencing circuit 500 may include eight second memory cells 710. Accordingly, weight programming of the second memory cells 710 may be performed such that the output currents of the second memory cells 710 flow differently, and the eight second memory cells 710 may output 2⁸ state values depending on whether each is activated or not. In addition, in a case where the second memory cells 710 is split-gate type memory cells, each of odd and even cells may output a positive state value and a negative state value. That is, the second memory cells 710 may output 2⁸ state values depending on the output of the each of the odd and even cells.

That is, in a case where the neural network system is configured such that the first memory cell has 2*ⁿ* state values, the self-referencing circuit 500 may include n number of second memory cells 710. In some embodiments,

according to the above description, because the weight programming of the target memory cell is performed according to the combination of output currents flowing through the second memory cells 710, the output currents can be combined to correspond to the state values of the weights. As a result, in response to the combination of output currents being applied to each of the target memory cells of the row line, to which the self-referencing circuit 500 is connected, through the pass gate 730, the weight programming may be performed so that each of the target memory cells has a preset target weight.

In an embodiment, the comparator 720 may output a result of comparison between a voltage across opposite ends of the second memory cells 710 and a preset comparator voltage (*V_{ref}*) as a digital signal. For example, in the comparator 720, in a case where the voltage across opposite ends of the second memory cells 710 is equal to the preset comparator voltage (*V_{ref}*), no current may flow between opposite ends of the comparator 720. Specifically, in a case where the target output current flows in the second memory cells 710 in response to the tuning gate voltages being applied to the second memory cells 710, the channel conductance of the second memory cells 710 is equal to the potential of the band gap circuit connected to the self-referencing circuit 500. That is, because the voltage across opposite ends of the second memory cells 710 input to the comparator 720 is equal to the comparator voltage, the comparator 720 may determine that tuning of the second memory cells 710 is completed using a digital signal.

In an embodiment, the comparator 720 may determine whether the self-referencing circuit 500 is connected to the neural network circuit and the weight programming is completed such that the target memory cell (i.e., the first memory cell) has the target weight. For example, in a case where current is applied to the target memory cell of the neural network circuit and the target memory cell has the target weight, the channel conductance of the target memory cell and the channel conductance of the second memory cells 710 of the self-referencing circuit 500 are equal. That is, because the voltage across opposite ends of the target memory cell input to the comparator 720 is equal to the comparator voltage, the comparator 720 may determine that the weight programming of the target memory cell is completed using a digital signal.

In an embodiment, a current flowing through the second memory cells 710 may pass through the pass gate 730 according to the digital signal.

In an embodiment, the second memory cells 710 of the self-referencing circuit 500 may be programmed by the bit-by-bit programming method or the iterative programming method. Specifically, the tuning gate voltages of the second memory cells 710 may be determined by the iterative programming method and applied to the second memory cells 710, respectively. As described above, the self-referencing circuit 500 is a small-scale embedded system determined according to the number of state values of the weights of the first memory cell, and thus may be rapidly programmed using the bit-by-bit programming method or the iterative programming method. In particular, high-accuracy programming may be performed in a short time by using the iterative programming method.

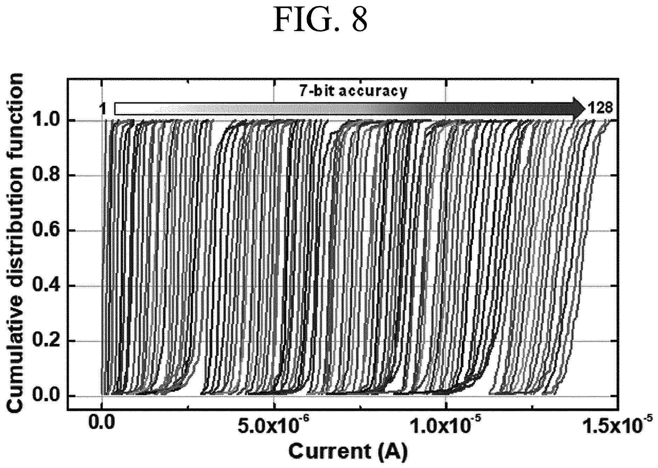

FIG. 8 is a graph showing the result of self-referential programming according to an embodiment.

Referring to FIG. 8, the cumulative distribution function for each current of the weight state value of each first memory cell may be checked as a result of self-referencing programming. It may be seen that in the high-density crossbar array, the respective weight state values are programmed to be clearly distinguishable.

In FIG. 8, the 7-bit states are shown, but this is illustration only, and the number of the weight state values is not limited thereto.

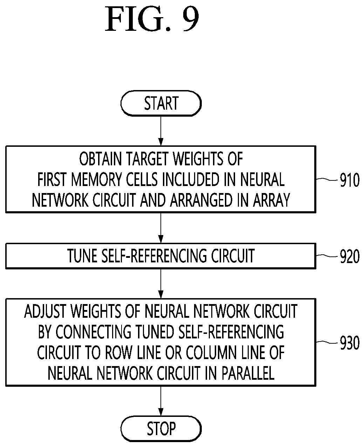

FIG. 9 is a flowchart of a method of implementing a neural network system according to an embodiment.

Referring to FIG. 9, the method of implementing a neural network system may be performed by the neural network system implementation device (hereinafter, referred to as a "device").

In step 910, the device may obtain target weights of first memory cells included in the neural network circuit and arranged in an array.

In step 920, the device may tune the self-referencing circuit.

In an embodiment, the self-referencing circuit may apply current to a row line or a column line connected thereto so that a plurality of target memory cells have target weights. In this regard, the target memory cells may mean all memory cells positioned on the row line or the column line to which the self-referencing circuit is connected.

In an embodiment, the self-referencing circuit may include a plurality of second memory cells each having a control gate to which a tuning gate voltage is applied, the second memory cells being connected to each other in parallel.

In an embodiment, the number of the plurality of second memory cells may be determined based on the number of weight states that the target memory cell may have.

In an embodiment, the self-referencing circuit may include a comparator that outputs a comparison result between the voltage across opposite ends of the second memory cell and the set comparator voltage as a digital signal.

In an embodiment, the device may apply different tuning gate voltages to the control gates so that different output currents flow through the plurality of second memory cells. In this regard, the output current may include 0, and the combination of output currents may correspond to the state value of the weight.

In an embodiment, the self-referencing circuit may apply a combination of output currents to a target memory cell such that the target memory cell has a preset target weight.

In step 930, the device may adjust the weights of the neural network circuit by electrically connecting the tuned self-referencing circuit to the row line or column line of the neural network circuit.

In an embodiment, the device may select a designated memory cell corresponding to the target line from among a plurality of target memory cells by designating the target line of the neural network circuit.

In an embodiment, the device may perform a programming operation on a target memory cell such that the target memory cell has a target weight.

In an embodiment, the device may provide a reference voltage such that a constant voltage is applied to the self-referencing circuit.

In addition, embodiments according to the present disclosure may be implemented in the form of a computer program executable by various components on a computer, and such a computer program may be recorded on a computer-readable medium. In this regard, the medium may include a magnetic medium, such as a hard disk, a floppy disk, or a magnetic tape, an optical recording medium, such as CD-ROM or a DVD, a magneto-optical medium, such as a floptical disk, and a hardware device specifically configured to store and execute program instructions, such as ROM, RAM, flash memory, or the like.

In addition, the computer program may be designed and configured specifically for the present disclosure, or may be known and available to a person having ordinary skill in the art of computer software. Examples of computer programs may include not only machine language code such as that produced by a compiler, but also high-level language code executable by a computer using an interpreter or the like.

According to an embodiment, methods according to various embodiments of the present disclosure may be included and provided in computer program products. The computer program products are commodities and may be traded between sellers and buyers. The computer program products may be distributed in the form of a machine-readable recording medium (e.g., compact disc read only memory (CD-ROM)) or distributed online (e.g., downloaded or uploaded) directly between two user devices through an application store (e.g., Play Store^{™}). In the case of online distribution, at least a portion of the computer program product may be at least temporarily stored or temporarily created in a machine-readable recording medium, such as a memory of a manufacturer's server, an application store server, or a relay server.

Unless explicitly stated herein or otherwise, the steps of the method according to the present disclosure may be performed in any suitable order. The present disclosure is not necessarily limited to the order in which the steps are described above. The use of any examples or illustrative terms herein is for the purpose of describing the present disclosure in detail only and the scope of the present disclosure is not limited to the examples or illustrative terms unless defined by the claims. A person having ordinary skill in the art will appreciate that various modifications, combinations, and alterations are possible depending on the design conditions and factors within the scope of the appended claims or equivalents thereof.

Accordingly, the spirit of the present disclosure should not be limited to the foregoing embodiments, and it should be understood that the scope of the appended claims as well as all scopes equivalent to or equivalently modified from the scope of the claims are included within the scope of the spirit of the present disclosure.

## Claims

1. A neural network system comprising:
a neural network circuit comprising first memory cells arranged in an array; and
a self-referencing circuit electrically connected to a row line or a column line of the neural network circuit and configured to apply current to the connected row line or column line so that a plurality of target memory cells have preset target weights,
wherein the target memory cells comprise
all memory cells positioned on the row line or the column line to which the self-referencing circuit is connected.

2. The neural network system of claim 1, wherein the self-referencing circuit comprises:
a plurality of second memory cells each having a control gate to which a tuning gate voltage is applied, the second memory cells being connected to each other in parallel; and
a comparator configured to output a comparison result between a voltage across opposite ends of the plurality of second memory cells and a preset comparator voltage as a digital signal.

3. The neural network system of claim 2, wherein the number of the plurality of second memory cells are determined based on the number of states of weights allowed to the target memory cells.

4. The neural network system of claim 3, wherein the plurality of second memory cells are configured such that different tuning gate voltages are applied to the control gates so that different output currents flow, where the currents include 0, and a combination of the output currents corresponds to the states of the weight.

5. The neural network system of claim 4, wherein the self-referencing circuit applies the combination of the output currents to the target memory cells so that the target memory cells have preset target weights.

6. The neural network system of claim 1, further comprising a write circuit configured to perform a programming operation on the target memory cells so that the target memory cells have the preset target weights.

7. The neural network system of claim 1, further comprising a band gap circuit configured to provide a reference voltage so that a constant voltage is applied to the self-referencing circuit.

8. A method of implementing a neural network system, the method comprising:
obtaining target weights of first memory cells included in a neural network circuit and arranged in an array form;
tuning a self-referencing circuit; and
adjusting weights of the neural network circuit by electrically connecting the tuned self-referencing circuit to a row line or a column line of the neural network circuit,
wherein the self-referencing circuit
applies a current to the connected row line or column line so that a plurality of target memory cells have the target weights, and
the target memory cells comprise
all memory cells positioned on the row line or the column line to which the self-referencing circuit is connected.

9. The method of claim 8, wherein the self-referencing circuit comprises:
a plurality of second memory cells each having a control gate to which a tuning gate voltage is applied, the second memory cells being connected to each other in parallel; and
a comparator configured to output a comparison result between a voltage across opposite ends of the plurality of second memory cells and a preset comparator voltage as a digital signal.

10. The method of claim 9, wherein the number of the plurality of second memory cells
are determined based on the number of states of weights allowed to the target memory cells.

11. The method of claim 10, wherein the tuning of the self-referencing circuit comprises applying different tuning gate voltages to the control gates so that different output currents flow through the plurality of second memory cells, where the output current include 0, and a combination of the output currents corresponds to the states of the weight.

12. The method of claim 11, wherein the self-referencing circuit applies the combination of the output currents to the target memory cells so that the target memory cells have preset target weights.

13. The method of claim 8, further comprising performing a programming operation on the target memory cells so that the target memory cells have the preset target weights.

14. The method of claim 8, further comprising providing a reference voltage so that a constant voltage is applied to the self-referencing circuit.

15. A computer-readable recording medium having recorded thereon a program to cause the method of claim 8 to be executed on a computer.
